# EUROPEAN PATENT APPLICATION

(11) **EP 3 943 638 A1**
(43) Date of publication of application: **26.01.2022**
(21) Application number: 21187530.7
(22) Date of filing: 23.07.2021
(51) Int. Cl.: C23C 14/32, H01J 37/32, C23C 14/20, C23C 14/02, C25D 5/10

(54) **METHOD FOR METALLIZING PLASTIC BY PRE-PLATING FOR ELECTROPLATING**

(30) Priority: 24.07.2020 CN 202010722631
(71) Applicant: Jomoo Kitchen & Bath Co., Ltd., Nan'an, Fujian 362308 (CN)
(72) Inventor: LIN, Xiaofa, NAN' AN CITY, 362308 (CN); LIN, Xiaoshan, NAN' AN CITY, 362308 (CN); HU, Zhengyu, NAN' AN CITY, 362308 (CN); LIU, Xiaolong, NAN' AN CITY, 362308 (CN); WANG, Hanchun, NAN' AN CITY, 362308 (CN)
(74) Representative: Verscht, Thomas Kurt Albert

(57) **Abstract**

A method for metallizing plastic by pre-plating for electroplating, forming a metal bonding layer and a metal transition layer using electro arc ion plating or magnetron sputtering in series, and then forming a metal conductive layer on the metal transition layer using the electro arc ion plating. At least forming the metal conductive layer comprises: disposing a magnetic filter device between a metal target and a vacuum chamber in which the plastic workpiece is placed, so that positively charged metal ions generated by the metal target are deflected by the magnetic filter device and then enter the vacuum chamber to be deposited on the surface of the plastic workpiece. In this disclosure, the particles evaporated from the metal target pass through the magnetic filter device with electromagnetic field deflection. Neutral particle clusters cannot be deposited on the surface of the workpiece. No metal particle clusters (large particles) are deposited on the surface of the film layer like in the traditional PVD process, the film is flatter, and the metalized plastic workpiece can be electroplated to obtain a high-quality mirror appearance.

## Description

### FIELD OF THE DISCLOSURE

The present disclosure relates to a method for metallizing plastic, and in particular relates to a method for metallizing plastic by pre-plating for electroplating.

### BACKGROUND OF THE DISCLOSURE

The purpose of plastic metallization is to deposit a conductive metal film layer on a surface of a non-conductive plastic workpiece. Plastic metal coating technology comprises spraying, physical vapor deposition (PVD), electroplating, etc. Existing methods of spraying in combination with physical vapor deposition are used to obtain workpieces having chromium-plated appearances. This process is suitable for flat workpieces with relatively simple workpiece shapes. For more complex workpiece shapes, there is a disadvantage of an uneven thickness of paint film and PVD film. The process also produces volatile organic compounds (VOCs) and other organic emissions, which is not green and environmentally friendly. The electroplating brings to a product to have advantages of high-quality appearance and high durability that other technologies cannot have. However, the electroplating can only be directly used on limited kinds of plastic surfaces, and a preprocessing of the electroplating has serious environmental pollution. Therefore pre-treating is needed.

Optional pre-treating for electroplating comprise PVD, etc. The principle of the PVD process is to generate instantaneous high temperature on the surface of the target material through argon ion bombardment to evaporate the material, and part of the material will be deposited on the surface of the workpiece in the form of aggregated metal particle clusters (large particles). The subsequent electroplating process enlarges the particle clusters, resulting in a large number of visible particles appearing on the surface of the workpiece, which cannot match the high-quality appearance standard of traditional electroplating.

### BRIEF SUMMARY OF THE DISCLOSURE

The objective of the present disclosure is to provide a method for metallizing plastic by pre-plating for electroplating to solve the deficiencies of the existing techniques.

In order to achieve the aforementioned objective, a technical solution of the present disclosure is as follows.

A method for metallizing plastic by pre-plating for electroplating, which comprises the following steps:
1) cleaning a plastic workpiece by an ion source;
2) forming a metal bonding layer on a surface of the plastic workpiece using electro arc ion plating or magnetron sputtering;
3) forming a metal transition layer on a surface of the metal bonding layer using the electro arc ion plating or the magnetron sputtering; and
4) forming a metal conductive layer on the metal transition layer using the electro arc ion plating;

Wherein in steps 2), 3) and 4), at least step 4) comprises: disposing a magnetic filter device between a metal target and a vacuum chamber in which the plastic workpiece is placed, so that positively charged metal ions generated by the metal target are deflected by the magnetic filter device and then enter the vacuum chamber to be deposited on the surface of the plastic workpiece.

Preferably, the metal bonding layer is one of chromium, zirconium, or titanium, and a thickness of the metal bonding layer is 40-150 nm.

Preferably, forming the metal transition layer by co-depositing comprises co-depositing a metal target being the same as the metal bonding layer and a metal target being the same as the metal conductive layer to form a mixed metal plating layer with a thickness of 40-150 nm.

Preferably, step 3) comprises at least disposing the magnetic filter device between the metal target being the same as the metal conductive layer and the vacuum chamber.

Preferably, the metal conductive layer is one of copper, nickel, or aluminum, and a thickness of the metal conductive layer is 100-1000 nm.

Preferably, step 1) comprises: putting the plastic workpiece into the vacuum chamber, turning on a rotating rack, drawing to a vacuum of less than 0.005 Pa, then introducing argon gas to reduce vacuum degree to 0.1-2 Pa, setting the ion source to 1000-3000 V, cleaning for 200-600 seconds, restoring the vacuum, and cooling the plastic workpiece at the same time.

Preferably, the magnetic filter device comprises an elbow tube and a magnetic generator, the target is disposed on an inlet of the elbow tube, the vacuum chamber is disposed on an outlet of the elbow tube, a normal of the inlet and a normal of the outlet are perpendicular to each other, and the magnetic generator adjusts a current of a coil to enable magnetic field lines to be parallel to the elbow tube.

Preferably, the method further comprises applying a positive bias voltage of 100-500 V to the elbow tube.

Preferably, a material of the plastic workpiece comprises acrylonitrile butadiene styrene (ABS), propylene carbonate (PC), polymethyl methacrylate (PMMA), or polyethylene terephthalate (PET).

Preferably, electroplating after step 4), wherein the electroplating comprises pyrophosphate copper - acid copper - semi bright nickel - bright nickel - bright chromium; or the electroplating comprises pyrophosphate copper - acid copper - bright nickel - bright chromium, wherein the bright chromium is trivalent chromium or hexavalent chromium.

Compared with the existing techniques, the technical solution has the following advantages.

Electro arc ion plating or magnetron sputtering technologies are used to evaporate the metal target. The evaporated particles pass through the magnetic filter device with electromagnetic field deflection. Neutral particle clusters cannot be deposited on the surface of the workpiece. The positively charged metal ions deflect under the Lorentz force, enter the vacuum chamber, and deposit on the surface of the workpiece to form the metal film layer. Since the film layer is almost all deposited by metal ions, no metal particle clusters (large particles) are deposited on the surface of the film layer like in the traditional PVD process, the film is flatter, and the metalized plastic workpiece can be electroplated to obtain a high-quality mirror appearance.

### BRIEF DESCRIPTION OF THE DRAWINGS

Fig. 1 illustrates a schematic diagram of a principle of a magnetic filter device of Embodiment; and
Fig. 2 illustrates electron micrographs of surfaces of electroplated film layers obtained in Embodiment 1 and a comparative embodiment.

### DETAILED DESCRIPTION OF THE EMBODIMENTS

The present disclosure will be further described in combination with the accompanying embodiments and drawings.

A method for metallizing plastic by pre-plating for electroplating is further described as follows.

Step 1): A plastic workpiece is cleaned by an ion source to increase an activity of a surface of the workpiece and enhance a bonding force between a metal film layer and a plastic substrate of the plastic workpiece. In detail, the plastic workpiece is put into a vacuum chamber of a PVD equipment, a rotating rack is turned on, and a vacuum of less than 0.005 Pa is drawn. Argon gas is injected to reduce vacuum degree to 0.1-2 Pa, a voltage of the ion source is set to 1000-3000 V, cleaning for 200-600 seconds, the vacuum is restored, and the plastic workpiece is cooled. A material of the plastic workpiece includes, but is not limited to, ABS (acrylonitrile butadiene styrene), PC (propylene carbonate), PMMA (polymethyl methacrylate), or PET (polyethylene terephthalate).

Step 2): A metal bonding layer is formed on the surface of the plastic workpiece using an electro arc ion plating method or a magnetron sputtering method. The metal bonding layer uses a metal having a high melting point, such as chromium, zirconium, titanium, etc. to enhance the bonding force between the metal film layer and the plastic substrate. A thickness of the metal bonding layer is about 40-150 nm.

Step 3): A metal transition layer is formed on the metal bonding layer using the electro arc ion plating method or the magnetron sputtering method. A metal target being the same as the metal bonding layer, and a metal target being the same as a metal conductive layer are co-deposited to form a mixed metal plating layer using co-depositing. A thickness of the metal transition layer is 40-150 nm.

Step 4): The metal conductive layer is formed on the metal transition layer using the electro arc ion plating method. The metal conductive layer uses good conductive metals, such as copper, nickel, aluminum, etc. to provide high conductivity and facilitate subsequent electroplating. A thickness of the metal conductive layer is 100-1000 nm.

In the aforementioned steps 2), 3), and 4), at least the step 4) comprises: a magnetic filter device is placed between a metal target and the vacuum chamber in which the plastic workpiece is placed, so that positively charged metal ions generated by the metal target are deflected by the magnetic filter device and then enter the vacuum chamber to be deposited on the surface of the plastic workpiece.

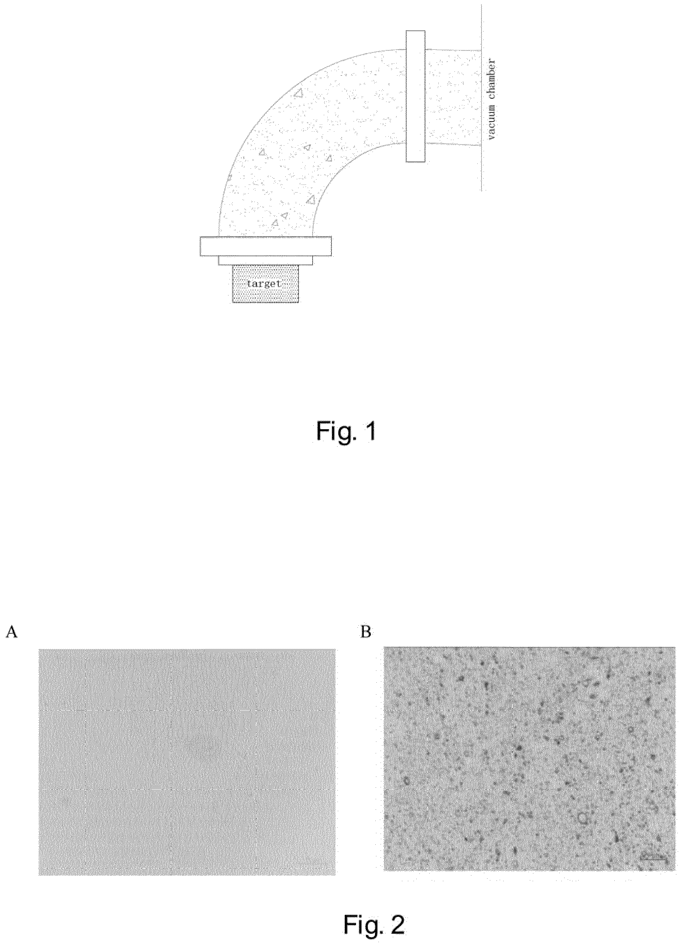

Referring to Fig. 1, the magnetic filter device of an embodiment has an elbow tube and is disposed with a magnetic generator. The target is disposed on an inlet of the elbow tube, and the vacuum chamber is disposed on an outlet of the elbow tube. A normal of the inlet and a normal of the outlet are preferably perpendicular to each other, that is, the elbow tube is deflected by 90°. Further, other angles can be selected according to an actual situation. Magnetic field lines generated by the magnetic generator are parallel to the elbow tube, so that Lorentz force is parallel to the elbow tube. Particles evaporated from the metal target pass through the magnetic filter device, and the positively charged metal ions deflect along the elbow tube due to Lorentz force to enter into the vacuum chamber by the outlet and are deposited on the surface of the workpiece to form the metal film layer. Neutral particle clusters (large particles) cannot be deposited on the surface of the workpiece, thereby the formed metal film layer is controlled to have a smooth, dense, and uniform appearance. A positive bias voltage of 100-500V is applied to the elbow tube to prevent metal ions from being deposited on the elbow tube.

In the present disclosure, at least a preparation of the metal conductive layer uses the magnetic filter device to ensure that the entire surface of the metal layer formed in the pre-plating has flat, dense, and uniform appearance. In addition, part or all of the preparations of the metal bonding layer and the metal transition layer can also use the magnetic filter device according to actual needs.

After the pre-plating is complete, the electroplating is carried out. The electroplating comprises pyrophosphate copper - acid copper - semi bright nickel - bright nickel - bright chromium. The processes after the acid copper can be adjusted according to actual preparation needs, for example, pyrophosphate copper - acid copper - bright nickel - bright chromium, and the bright chromium can be trivalent chromium or hexavalent chromium. Traditional electroplating further comprises a series of pre-treating, such as coarsening - catalyzing - debonding - chemical nickel. Wastewater of the coarsening comprises a large amount of dichromic acid waste solution. The present disclosure skips the aforementioned pre-treating.

### Embodiment 1

A method for metallizing plastic by electroplating on the surface of a plastic shower is provided.

Step 1): the workpiece is cleaned and dried and then is put in the vacuum chamber, the rotating rack is turned on, a vacuum of less than 0.005 Pa is drawn, argon gas is introduced to reduce vacuum degree to 0.3 Pa, the ion source is set to 1500 V, cleaning for 300 seconds, then the vacuum is restored, and at the same time, the workpiece is cooled.

Step 2): A chromium target is processed by magnetron sputtering, and the current is set to 20 A. After 180 seconds of deposition, the vacuum is restored, and at the same time, the workpiece is cooled to form a chromium layer with a thickness of about 40 nm.

Step 3): The chromium target is processed by magnetron sputtering, the current is set to 20 A, the magnetic filter device is used, a copper target is processed by arc discharge, and the current is set to 150 A. The current configured to process the chromium target by magnetron sputtering is gradually reduced to 10 A within 600 seconds, then the vacuum is restored, and at the same time, the workpiece is cooled to form a chromium-copper alloy layer with a thickness of about 50 nm.

Step 4): The magnetic filter device is used, the copper target is processed by the arc discharge, and the current is set to 150 A. The copper layer is deposited to a thickness of about 300 nm, and then the film plating is complete.

Step 5): A detailed electroplating is as follows: pyrophosphate copper - acid copper - semi bright nickel - bright nickel - bright chromium. Reference can be made to conventional electroplating for the aforementioned step. The workpiece is electroplated to obtain a mirror chromium appearance.

### Comparative embodiment

It differs from Embodiment 1 in that the comparative embodiment does not use the magnetic filter device, and the rest is the same.

Referring to Fig. 2, electron micrographs of surfaces of electroplated film layers obtained in Embodiment 1 (A) and the comparative embodiment (B) are illustrated. An electroplated layer obtained in Embodiment 1 illustrates a mirror appearance, the film layer is flat, dense, and is high quality. An electroplated layer obtained in the comparative embodiment has many pits in appearance and cannot meet requirements of high quality products.

The electroplated film layer obtained in Embodiment 1 has been tested and has mechanical properties and durability similar to the traditional electroplated film layer.

The invention may be summarized as follows: A method for metallizing plastic by pre-plating for electroplating, forming a metal bonding layer and a metal transition layer using electro arc ion plating or magnetron sputtering in series, and then forming a metal conductive layer on the metal transition layer using the electro arc ion plating. At least forming the metal conductive layer comprises: disposing a magnetic filter device between a metal target and a vacuum chamber in which the plastic workpiece is placed, so that positively charged metal ions generated by the metal target are deflected by the magnetic filter device and then enter the vacuum chamber to be deposited on the surface of the plastic workpiece. In this disclosure, the particles evaporated from the metal target pass through the magnetic filter device with electromagnetic field deflection. Neutral particle clusters cannot be deposited on the surface of the workpiece. No metal particle clusters (large particles) are deposited on the surface of the film layer like in the traditional PVD process, the film is flatter, and the metalized plastic workpiece can be electroplated to obtain a high-quality mirror appearance.

The aforementioned embodiments are merely used to further disclose the method for metallizing plastic by pre-plating for electroplating of the present disclosure, and the scope of the disclosure is not limited thereto. Thus, it is intended that the present disclosure cover any modifications and variations of the presently presented embodiments provided they are made without departing from the appended claims and the specification of the present disclosure.

## Claims

1. A method for metallizing plastic by pre-plating for electroplating, **characterized in that** the method comprises:
1) cleaning a plastic workpiece by an ion source;
2) forming a metal bonding layer on a surface of the plastic workpiece using electro arc ion plating or magnetron sputtering;
3) forming a metal transition layer on a surface of the metal bonding layer using the electro arc ion plating or the magnetron sputtering; and
4) forming a metal conductive layer on the metal transition layer using the electro arc ion plating, wherein:
in steps 2), 3) and 4), at least step 4) comprises: disposing a magnetic filter device between a metal target and a vacuum chamber in which the plastic workpiece is placed, so that positively charged metal ions generated by the metal target are deflected by the magnetic filter device and then enter the vacuum chamber to be deposited on the surface of the plastic workpiece.

2. The method for metallizing plastic by pre-plating for electroplating according to claim 1, **characterized in that**:
the metal bonding layer is one of chromium, zirconium, or titanium, and
a thickness is 40-150 nm.

3. The method for metallizing plastic by pre-plating for electroplating according to claim 1 and/or 2, **characterized in that**: forming the metal transition layer by co-depositing comprises co-depositing a metal target being the same as the metal bonding layer and a metal target being the same as the metal conductive layer to form a mixed metal plating layer with a thickness of 40-150 nm.

4. The method for metallizing plastic by pre-plating for electroplating according to any one or more of claims 1 to 3, in particular, according to claim 3, **characterized in that**: step 3) comprises at least disposing the magnetic filter device between the metal target being the same as the metal conductive layer and the vacuum chamber.

5. The method for metallizing plastic by pre-plating for electroplating according to any one or more of claims 1 to 4, **characterized in that**:
the metal conductive layer is one of copper, nickel, or aluminum, and
a thickness is 100-1000 nm.

6. The method for metallizing plastic by pre-plating for electroplating according to any one or more of claims 1 to 5, **characterized in that**:
step 1) comprises:
putting the plastic workpiece into the vacuum chamber,
turning on a rotating rack,
drawing to a vacuum of less than 0.005 Pa,
then introducing argon gas to reduce vacuum degree to 0.1-2 Pa,
setting the ion source to 1000-3000 V,
cleaning for 200-600 seconds,
restoring the vacuum, and
cooling the plastic workpiece at the same time.

7. The method for metallizing plastic by pre-plating for electroplating according to any one or more of claims 1 to 6, **characterized in that**:
the magnetic filter device comprises an elbow tube and a magnetic generator,
the target is disposed on an inlet of the elbow tube,
the vacuum chamber is disposed on an outlet of the elbow tube,
a normal of the inlet and a normal of the outlet are perpendicular to each other, and
the magnetic generator adjusts a current of a coil to enable magnetic field lines to be parallel to the elbow tube.

8. The method for metallizing plastic by pre-plating for electroplating according to claim 7, **characterized in that**: the method comprises applying a positive bias voltage of 100-500 V to the elbow tube.

9. The method for metallizing plastic by pre-plating for electroplating according to any one or more of claims 1 to 8, **characterized in that**: a material of the plastic workpiece comprises acrylonitrile butadiene styrene (ABS), propylene carbonate (PC), polymethyl methacrylate (PMMA), or polyethylene terephthalate (PET).

10. The method for metallizing plastic by pre-plating for electroplating according to any one or more of claims 1 to 9, **characterized in that**, which comprises:
electroplating after step 4), wherein:
the electroplating comprises pyrophosphate copper - acid copper - semi bright nickel - bright nickel - bright chromium; or
the electroplating comprises pyrophosphate copper - acid copper - bright nickel - bright chromium, wherein:
the bright chromium is trivalent chromium or hexavalent chromium.
